# EUROPÄISCHE PATENTSCHRIFT

(11) **EP 2 513 355 B1**
(45) Veröffentlichungstag und Bekanntmachung des Hinweises auf die Patenterteilung: **23.08.2017**
(21) Anmeldenummer: 10785038.0
(22) Anmeldetag: 25.11.2010
(51) Int. Cl.: C23C 18/06, C23C 18/14, H01L 21/02, H01L 51/00, C23C 18/12

(54) **VERFAHREN ZUR HERSTELLUNG VON INDIUMOXID-HALTIGEN SCHICHTEN, NACH DEM VERFAHREN HERGESTELLTE INDIUMOXID-HALTIGE SCHICHTEN UND IHRE VERWENDUNG**
METHOD FOR PRODUCING LAYERS CONTAINING INDIUM OXIDE, LAYERS CONTAINING INDIUM OXIDE PRODUCED ACCORDING TO SAID METHOD AND THE USE THEREOF
PROCÉDÉ DE PRÉPARATION DE COUCHES CONTENANT DE L'OXYDE D'INDIUM, COUCHES CONTENANT DE L'OXYDE D'INDIUM PRODUITES AU MOYEN DU PROCÉDÉ ET LEUR UTILISATION

(30) Priorität: 18.12.2009 DE 102009054997
(43) Veröffentlichungstag der Anmeldung: 24.10.2012
(73) Patentinhaber: Evonik Degussa GmbH, 45128 Essen (DE)
(72) Erfinder: STEIGER, Jürgen, 40237 Düsseldorf (DE); PHAM, Duy Vu, 46047 Oberhausen (DE); THIEM, Heiko, 64625 Bensheim (DE); MERKULOV, Alexey, 67059 Ludwigshafen (DE); HOPPE, Arne, 44623 Herne (DE)
(86) Internationale Anmeldenummer: PCT/EP2010/068185
(87) Internationale Veröffentlichungsnummer: WO 2011/073005

(56) Entgegenhaltungen:
- DE-A1-102007 013 181
- JP-A- 2000 016 812

## Beschreibung

Die vorliegende Erfindung betrifft ein Verfahren zur Herstellung von Indiumoxid-haltigen Schichten, die mit dem erfindungsgemäßen Verfahren herstellbaren Indiumoxid-haltigen Schichten sowie deren Verwendung.

Die Herstellung halbleitender elektronischer Bauteilschichten über Druck- und andere flüssige Abscheidungsprozesse ermöglicht im Vergleich zu vielen anderen Verfahren, wie z.B. Chemical Vapor Deposition (CVD), eine prozesstechnische Vereinfachung und weitaus niedrigere Produktionskosten, da die Deposition des Halbleiters hier in einem kontinuierlichen Prozess erfolgen kann. Darüber hinaus eröffnet sich im Falle niedrigerer Prozesstemperaturen die Möglichkeit, auch auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 cm²/Vs bei einem Bauteil mit einer Kanallänge von 20 µm bei 50 V Gate-Source-Spannung und 50 V Source-Drain-Spannung aufweisen.

Da das Material der über Druck oder andere flüssige Abscheidungsverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, In₂O₃) ist aufgrund der großen Bandlücke zwischen 3.6 und 3.75 eV (gemessen für aufgedampfte Schichten, H.S. Kim, P.D. Byrne, A. Facchetti, T.J. Marks; J. Am. Chem. Soc. 2008, 130, 12580-12581) ein vielversprechender und somit gerne eingesetzter Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen. Bislang können jedoch solche Werte durch Prozessierung aus Lösung noch nicht erreicht werden (H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513).

Indiumoxid wird oft vor allem zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxid-haltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches oder dispergierbares Vorprodukt nach dem Verdrucken einer entsprechenden Zusammensetzung zu einer Indiumoxid-haltigen Schicht umgesetzt wird. Unter einem Precursor ist dabei eine thermisch oder mit elektromagnetischer Strahlung zersetzbare Verbindung, mit der in An- oder Abwesenheit von Sauerstoff oder anderen Oxidationsstoffen Metalloxid-haltige Schichten gebildet werden können, zu verstehen. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-Schichten. So können neben Indiumsalzen auch Indium-Alkoxide (homoleptische, d.h. nur Indium und Alkoxid-Reste aufweisende Verbindungen, insbesondere Indiumverbindungen des Typs In(OR)₃ mit R = Alkyl- bzw. Oxyalkylrest) und Indium-Halogen-Alkoxide (d.h. sowohl Halogen- als auch Alkoxidreste aufweisende Indiumverbindungen, insbesondere dreiwertige Indiumverbindungen des Typs InXₘ(OR)₃₋ₘ mit X = Halogen, R = Alkyl- bzw. Oxyalkylrest und m = 1,2) als Precursoren für die Herstellung von Indiumoxid-haltigen Schichten eingesetzt werden.

Zum Beispiel beschreiben Marks et al. Bauteile, bei deren Herstellung eine Precursor-haltige Zusammensetzung umfassend das Salz InCl₃ sowie der Base Monoethanolamin (MEA) gelöst in Methoxyethanol eingesetzt wird. Nach Aufschleudern (Spin-coating) der Zusammensetzung wird die entsprechende Indiumoxid-Schicht durch eine thermische Behandlung bei 400 °C erzeugt (H.S. Kim, P.D. Byrne, A. Facchetti, T.J. Marks; J. Am. Chem. Soc. 2008, 130, 12580-12581 and supplemental informations).

Gegenüber Indiumsalz-haltigen Zusammensetzungen bieten Indiumalkoxid- bzw. Indium-Halogen-Alkoxid-haltige Zusammensetzungen den Vorteil, dass sie bei geringeren Temperaturen zu Indiumoxid-haltigen Beschichtungen umgewandelt werden können. Weiterhin wurde bislang davon ausgegangen, dass halogenhaltige Precursoren potentiell den Nachteil haben, zu halogenhaltigen Schichten mit verminderter Qualität zu führen. Aus diesem Grund wurden in der Vergangenheit Versuche zur Schichtbildung mit Indiumalkoxiden vorgenommen.

Indium-Alkoxide sowie Indium-Halogen-Alkoxide und ihre Synthese sind bereits seit den siebziger Jahren des vorigen Jahrhunderts beschrieben.

So fassen zum Beispiel Carmalt et al. in einem Review-Artikel die zu diesem Zeitpunkt bekannten Daten zu Synthese, Struktur und Reaktivitäten von u.a. Indium(III)alkoxiden und - alkylalkoxiden zusammen (Carmalt et al., Coord. Chem Rev. 250 (2006), 682 - 709).

Eine der am längsten bekannten Synthesen von Indiumalkoxiden beschreiben Chatterjee et al. Sie beschreiben die Herstellung von Indiumtrisalkoxid In(OR)₃ aus Indium(III)chlorid (InCl₃) mit Natriumalkoxid NaOR, wobei R für-Methyl, -Ethyl, iso-Propyl, n-, s-, t-Butyl und -Pentyl Reste steht (S. Chatterjee, S. R. Bindal, R.C. Mehrotra; J. Indian Chem. Soc.1976, 53, 867).

Bradley et al. berichten von einer ähnlichen Reaktion wie Chatterjee et al. und erhalten bei annähernd identischen Edukten (InCl₃, Isopropyl-Natrium) und Reaktionsbedingungen einen Indium-Oxo-Alkoxid-Cluster mit Sauerstoff als Zentralatom (D.C. Bradley, H. Chudzynska, D.M. Frigo, M.E. Hammond, M.B. Hursthouse, M.A. Mazid; Polyhedron 1990, 9, 719).

Eine besonders gute Variante dieses Verfahrens, die zu einer besonders niedrigen Verunreinigung an Chlor im Produkt führt, wird in US 2009-0112012 A1 beschrieben. Die Bestrebungen, einen möglichst niedrigen Grad an Chlor-Verunreinigungen im Produkt zu erreichen, werden dabei darauf zurückgeführt, dass bislang davon ausgegangen wurde, dass Chlor-Verunreinigungen zu einer Verminderung der Performance oder der Lebensdauer elektronischer Bauteile beitragen (vergleiche zum Beispiel US 6,426,425 B2).

Ebenfalls auf einem Indiumhalogenid, jedoch auf anderen Basen, basiert das in US 5,237,081 A beschriebene Verfahren zur Herstellung reiner Indiumalkoxide, bei denen ein Indium(III)halogenid in einem basischen Medium mit einem Alkohol umgesetzt wird. Die Base soll eine starke Base mit niedriger Nucleophilie sein. Beispielhaft genannte Basen sind neben exemplarisch genannten komplexen cyclischen Heterocyclen tertiäre Amine.

US 4,681,959 A beschreibt ein allgemeines zweistufiges Verfahren zur Herstellung von Metallalkoxiden (insbesondere Tetraalkoxyverbindungen wie Tetramethyltitanat), bei dem ein Halogenid eines mindestens zweiwertigen Metalls mit einem Alkohol ggf. in Gegenwart eines aromatischen Lösemittels zunächst zu einem Zwischenprodukt (einer Halogen-Alkoxy-Verbindung des Metalls) umgesetzt wird. Anschließend wird das Zwischenprodukt mit einem Alkohol in Gegenwart eines Wasserstoffhalogenid-Akzeptors (insbesondere einem tertiären Amin) unter Bildung des Metallalkoxids umgesetzt.

Alternative Syntheserouten zu homoleptischen Indiumalkoxid-Komplexen werden von Seigi Suh et al. in J. Am. Chem. Soc. 2000, 122, 9396 - 9404 beschrieben. Die dort beschriebenen Verfahren sind jedoch sehr aufwändig und/oder basieren auf nicht kommerziell erhältlichen (und somit erst nachteilig in einem vorgelagerten Schritt zu synthetisierenden) Edukten.

Ein allgemeines Verfahren zur Herstellung von Halogen-Alkoxy-Metall-Verbindungen ist in US 4,681,959 A beschrieben: Dort wird allgemein ein zweistufiges Verfahren zur Herstellung von Metallalkoxiden (insbesondere von Tetraalkoxyverbindungen wie Tetramethyltitanat) beschrieben, bei dem ein Halogenid eines mindestens zweiwertigen Metalls mit einem Alkohol - ggf. in Gegenwart eines aromatischen Lösemittels - zunächst zu einem Zwischenprodukt (einer Halogen-Alkoxy-Verbindung des Metalls) umgesetzt wird. Bevorzugt wird dabei entstehender Halogenwasserstoff mit einem Inertgas wie z.B. Stickstoff ausgetrieben.

Indiumhalogenalkoxide und ihre Synthese sind auch in JP 02-113033 A und JP 02-145459 A beschrieben. So offenbart JP 02-113033 A, dass chlorhaltige Alkoxide von Indium nach Lösung von Indiumchlorid in einem dem einzubauenden Alkoxidrest entsprechenden Alkohol durch nachfolgende Zugabe eines bestimmten Anteils eines Alkalimetalls oder einer Alkalimetallalkoxids hergestellt werden können. Ein entsprechendes Verfahren beschreibt auch JP 02-145459 A.

Die Herstellung von Indiumoxidschichten aus Indiumalkoxiden und Indium-Halogen-Alkoxiden kann prinzipiell i) durch Sol-Gel-Prozesse, bei denen die eingesetzten Precursoren in Gegenwart von Wasser durch Hydrolyse und nachfolgende Kondensation zunächst zu Gelen reagieren und dann in Metalloxide konvertiert werden, oder ii) aus nichtwässriger Lösung erfolgen.

Die Herstellung Indiumoxid-haltiger Schichten aus Indiumalkoxiden über Sol-Gel-Verfahren in Gegenwart signifikanter Mengen von Wasser gehört zum Stand der Technik. WO 2008/083310 A1 beschreibt zum Beispiel Verfahren zur Herstellung anorganischer Schichten bzw. organischer/anorganischer Hybridschichten auf einem Substrat, bei dem ein Metallalkoxid (z.B. eines der generischen Formel R¹M (OR²)_{y-x}) oder ein Präpolymer davon auf ein Substrat aufgebracht und dann die resultierende Metallalkoxid-Schicht in Gegenwart von und Reaktion mit Wasser unter Zufuhr von Wärme ausgehärtet wird. Bei den einsetzbaren Metallalkoxiden kann es sich u. a. um ein Indiumalkoxid handeln.

Auch JP 01-115010 A befasst sich mit einer thermischen Konvertierung bei einem Sol-Gel-Prozess. In diesem Dokument werden Zusammensetzungen für transparente, leitende dünne Schichten beschrieben, die eine lange Topfzeit haben, als Zusammensetzung nicht hydrolysieren, und die chlorhaltige Indiumalkoxide der Formel In(OR)ₓCl₃₋ₓaufweisen. Diese Zusammensetzungen können nach dem Aufbringen auf ein Substrat, Gelierung des Alkoxids auf dem Substrat durch den Wasseranteil in Luft, nachfolgende Trocknung bei bis zu 200 °C bei Temperaturen von 400 - 600 °C konvertiert werden.
JP 02-113033 A beschreibt Verfahren zum Aufbringen einer antistatischen Beschichtung auf ein nicht-metallisches Material, bei dem das nicht-metallische Material mit einer Zusammensetzung umfassend ein chlorhaltiges Indium-Alkoxid beschichtet, die Zusammensetzung an Luft geliert und nachfolgend calciniert wird.

JP 09-157855 A beschreibt ein Sol-Gel-Verfahren zur Herstellung einer Metalloxid-Schicht, bei dem ein durch Hydrolyse hergestelltes Metalloxid-Sol aus einem Metallalkoxid oder einem Metallsalz (z.B. einem Indiumalkoxid oder-salz) auf die Oberfläche eines Substrats gebracht wird, ggf. bei einer Temperatur, bei der das Gel noch nicht kristallisiert, getrocknet wird und mit UV-Strahlung von weniger als 360 nm bestrahlt wird.

Auch JP 2000-016812 A beschreibt ein Verfahren zur Herstellung einer Metalloxidschicht über ein Sol-Gel-Verfahren. Bei diesem wird das Substrat mit einer Beschichtungszusammensetzung eines Metall-Oxid-Sols aus einem Metallsalz oder Metallalkoxid, insbesondere einer In₂O₃-SnO₂-Zusammensetzung, beschichtet und mit UV-Strahlung einer Wellenlänge kleiner als 360 nm bestrahlt und wärmebehandelt.

JP 59-198606 A beschreibt Zusammensetzungen zur Bildung transparenter elektrisch leitender Schichten, die InClₓ(OR)₃₋ₓ und ein organisches Lösemittel aufweisen und einen Wasseranteil von 0,1 - 10 % bezogen auf das organische Lösemittel haben. Somit handelt es sich bei dieser Zusammensetzung um ein Sol eines Indium-Halogen-Alkoxids. Zur Bildung der transparenten leitenden Schicht wird die Zusammensetzung nach Aufbringen auf ein Substrat und Trocknung bei typischerweise 150 °C bei Temperaturen von bevorzugt 300 °C gebrannt.

Nachteilig an dem Einsatz von Sol-Gel-Verfahren ist jedoch, dass die Hydrolyse-Kondensations-Reaktion automatisch in Anwesenheit von Wasser gestartet wird und nach ihrem Start nur schlecht kontrollierbar ist. Wird der Hydrolyse-Kondensations-Prozess wie z.B. im Falle von JP 09-157855 A, JP 2000-016812 A und JP 59-198606 A bereits vor dem Aufbringen auf das Substrat gestartet, sind die zwischenzeitlich erzeugten Gele aufgrund ihrer erhöhten Viskosität oft für Verfahren zum Erzeugen feiner Oxidschichten nicht geeignet. Wird der Hydrolyse-Kondensations-Prozess wie im Falle von WO 2008/083310 A1, JP 01-115010 A oder JP 02-113033 A dagegen erst nach dem Aufbringen auf das Substrat durch Zufuhr von Wasser in flüssiger Form oder als Dampf gestartet, führen die so resultierenden schlecht durchmischten und inhomogenen Gele oft zu entsprechend inhomogenen Schichten mit nachteiligen Eigenschaften.

Aus diesem Grund sind wasserfreie Precursor-basierte Verfahren zur Herstellung Indiumoxidhaltiger Schichten, d.h. Verfahren, die nicht über einen Sol-Gel-Prozess ablaufen, von Interesse.

So beschreibt JP 2007-042689 A Metallalkoxid-Lösungen, die Indiumalkoxide enthalten können, sowie Verfahren zur Herstellung von Halbleiterbauelementen, die diese Metallalkoxid-Lösungen einsetzen. Die Metallalkoxid-Filme werden thermisch behandelt und zur Oxid-Schicht umgewandelt.

JP 02-145459 A beschreibt Indium-Halogen-Alkoxid-haltige Beschichtungszusammensetzungen, die bei Lagerung nicht hydrolysieren und die durch Calcinierung in eine Indiumoxid-haltige Schicht umgewandelt werden können.

JP 59-198607 A beschreibt Verfahren zur Herstellung transparenter leitender Schichten, die einen Schutzfilm aus verschiedenen Harzen aufweisen können. Die transparente leitende Schicht kann eine Indiumoxid-haltige Schicht sein, und kann über ein Flüssigphasenverfahren hergestellt werden, bei dem eine entsprechende Zusammensetzung auf ein Substrat aufgebracht, getrocknet und thermisch konvertiert wird. Gemäß den Beispielen kann eine lnCl(OC₃H₇)₂ enthaltende Zusammensetzung eingesetzt werden.

JP 11-106935 A beschreibt ein Verfahren zur Herstellung eines Oxid-basierten transparenten leitenden Films, bei dem u. a. eine wasserfreie Zusammensetzung umfassend ein Alkoxid eines Metalls (z.B. Indium) auf ein Substrat aufgebracht und erhitzt wird. Der Film kann weiterhin anschließend mit UV- oder VIS-Strahlung konvertiert werden in eine Metalloxid-basierte Dünnschicht.

Auch die bisher bekannten Verfahren zur wasserfreien Herstellung Indiumoxid-haltiger Schichten haben jedoch Nachteile: Eine rein thermisch durchgeführte Konvertierung hat den Nachteil, dass mit ihr keine feinen Strukturen hergestellt werden können und dass mit ihr weiterhin keine präzise Steuerung der resultierenden Schichteigenschaften möglich ist.

Ausschließlich über Strahlung erfolgende Konvertierungen haben weiterhin den Nachteil, dass sie über eine längere Zeit sehr hohe Energiedichten erfordern und insofern apparativ sehr aufwändig sind. Weiterhin haben alle bislang zur Verfügung stehenden wasserfreien Verfahren zur Herstellung Indiumoxid-haltiger Schichten den Nachteil, dass die resultierenden Schichten nicht ausreichend gute elektrische Eigenschaften, insbesondere Feldeffektbeweglichkeiten µ_{FET} aufweisen.

Es stellt sich somit die Aufgabe, ein Verfahren zur Herstellung Indiumoxid-haltiger Schichten bereitzustellen, das die bekannten Nachteile des Standes der Technik vermeidet und das insbesondere auch zur Herstellung feiner Strukturen geeignet ist, keine hohen Energiedichten über längere Zeit erfordert, apparativ wenig aufwändig ist und zu Schichten mit besseren elektrischen Eigenschaften, insbesondere Feldeffektbeweglichkeiten führt.

Diese Aufgabe wird erfindungsgemäß gelöst durch ein Flüssigphasen-Verfahren zur Herstellung Indiumoxid-haltiger Schichten aus nichtwässriger Lösung gemäß Anspruch 1, bei dem eine wasserfreie Zusammensetzung enthaltend mindestens ein Indium-Halogen-Alkoxid der generischen Formel InX(OR)₂ mit R = Alkylrest und/oder Alkoxyalkylrest und X = F, Cl, Br oder I und mindestens ein Lösemittel bzw. Dispersionsmedium in der Reihenfolge der Punkte a) bis d) in wasserfreier Atmosphäre
a) auf ein Substrat aufgebracht,
b) die auf dem Substrat aufgebrachte Zusammensetzung mit elektromagnetischer Strahlung einer Wellenlänge ≤ 360 nm bestrahlt und
c) ggf. getrocknet wird, und dann
d) thermisch in eine Indiumoxid-haltige Schicht konvertiert wird.

Bei dem erfindungsgemäßen Flüssigphasen-Verfahren zur Herstellung Indiumoxid-haltiger Schichten aus nichtwässriger Lösung handelt es sich um ein Verfahren umfassend mindestens einen Verfahrensschritt, bei dem das zu beschichtende Substrat mit einer flüssigen nichtwässrigen Lösung enthaltend mindestens ein Indium-Halogen-Alkoxid beschichtet, mit elektromagnetischer Strahlung bestrahlt, ggf. nachfolgend getrocknet wird und anschließend thermisch konvertiert wird. Insbesondere handelt es sich bei diesem Prozess nicht um einen Sputter-, CVD- oder Sol-Gel-Prozess. Unter flüssigen Zusammensetzungen im Sinne der vorliegenden Erfindung sind solche zu verstehen, die bei SATP-Bedingungen ("Standard Ambient Temperature and Pressure"; T = 25 °C und p = 1013 hPa) und bei Aufbringen auf das zu beschichtende Substrat flüssig vorliegen. Unter einer nichtwässrigen Lösung bzw. einer wasserfreien Zusammensetzung ist dabei hier und im Folgenden eine Lösung bzw. Formulierung zu verstehen, die nicht mehr als 500 ppm H₂O aufweist.

Besonders bevorzugt lässt sich das erfindungsgemäße Verfahren weiterhin zur Erzielung besonders guter Ergebnisse in einer wasserfreien Atmosphäre, d.h. in einer Atmosphäre mit einem Wassergehalt von maximal 500 ppm durchführen.

Unter dem Verfahrensprodukt des erfindungsgemäßen Verfahrens, der Indiumoxid-haltigen Schicht, ist eine metall- bzw. halbmetallhaltige Schicht zu verstehen, die Indiumatome bzw. - ionen aufweist, die im Wesentlichen oxidisch vorliegen. Gegebenenfalls kann die Indiumoxid-haltige Schicht auch noch Stickstoff- (aus der Reaktion), Kohlenstoff- (insbesondere Carben-), Halogen- und/oder Alkoxid-Anteile aus einer nicht vollständigen Konvertierung oder einer unvollständigen Entfernung entstehender Nebenprodukte aufweisen. Die Indiumoxid-haltige Schicht kann dabei eine reine Indiumoxid-Schicht sein, d.h. bei Nichtberücksichtigung etwaiger Stickstoff-, Kohlenstoff- (insbesondere Carben-), Alkoxid- oder Halogen-Anteile im Wesentlichen aus oxidisch vorliegenden Indiumatomen bzw. -ionen bestehen, oder anteilig noch weitere Metalle, Halbmetalle oder Nichtmetalle die selbst in elementarer oder oxidischer Form vorliegen können, aufweisen. Zur Erzeugung reiner Indiumoxid-Schichten sollten bei dem erfindungsgemäßen Verfahren nur Indium-Halogen-Alkoxide, bevorzugt nur ein Indium-Halogen-Alkoxid, eingesetzt werden. Im Gegensatz dazu sind zur Erzeugung auch andere Metalle, Halbmetalle und/oder Nichtmetalle aufweisender Schichten neben den Indium-Halogen-Alkoxiden auch Precursoren dieser Elemente in der Oxidationsstufe 0 (zur Herstellung von Schichten enthaltend weitere Metalle in neutraler Form) bzw. Sauerstoff-haltige Precursoren enthaltend die Elemente in positiver Oxidationsstufe (wie z.B. andere Metallalkoxide oder Metallhalogenalkoxide) einzusetzen.

Überraschenderweise wurde weiterhin festgestellt, dass die bisherige Annahme, dass halogenhaltige Precursoren zwangsläufig zu nachteiligen Schichten führen, nicht immer zutrifft. So resultieren bei dem erfindungsgemäßen Verfahren, bei dem eine flüssige Precursor-Zusammensetzung auf ein Substrat aufgebracht wird und der Beschichtungsfilm vor einer thermischen Konvertierung zunächst mit UV-Strahlung behandelt wird, im Falle der Verwendung von Indiumchlordialkoxiden anstelle von Indiumalkoxiden sogar bessere Schichten, da diese bessere elektrische Eigenschaften, insbesondere eine höhere Feldeffektbeweglichkeit aufweisen Weiterhin können im Falle der Verwendung von Indiumhalogendialkoxiden anstelle von Indiumalkoxiden weiterhin überraschenderweise amorphere Schichten erzielt werden. Amorphe Schichten besitzen gegenüber einer Schicht aus einzelnen Nanokristallen den Vorteil einer größeren Homogenität, was sich ebenfalls in besseren elektrischen Eigenschaften, insbesondere Feldeffektbeweglichkeiten, bemerkbar macht.

Unter den Alkyl- bzw. Alkoxyalkylresten R der Indium-Halogen-Alkoxide sind dabei bevorzugt C1- bis C15-Alkyl- oder Alkoxyalkylgruppen, d.h. Alkyl- oder Alkoxyalkylgruppen mit insgesamt 1-15 Kohlenstoffatomen, zu verstehen. Bevorzugt handelt es sich um einen Alkyl- bzw. Alkoxyalkylrest R ausgewählt aus -CH₃, -CH₂CH₃, -CH₂CH₂OCH₃, -CH(CH₃)₂ oder -C(CH₃)₃.

Ein Indium-Halogen-Alkoxid kann identische bzw. unterschiedliche Reste R aufweisen. Bevorzugt werden für das erfindungsgemäße Verfahren jedoch Indium-Halogen-Alkoxide eingesetzt, die den gleichen Alkyl- bzw. Alkoxyalkylrest R aufweisen.

Prinzipiell können alle Halogene in dem Indium-Halogen-Alkoxid eingesetzt werden. Ganz besonders gute Ergebnisse werden jedoch erzielt, wenn Indium-Chlor-Alkoxide eingesetzt werden.

Beste Ergebnisse werden erzielt, wenn das eingesetzte Indium-Halogen-Alkoxid InCl(OMe)₂, InCl(OCH₂CH₂OCH₃), InCl(OEt)₂, InCl(OiPr)₂ oder InCl(OtBu)₂ ist.

Das Indium-Halogen-Alkoxid InX(OR)₂ wird bevorzugt in Anteilen von 0,1 bis 10 Gew.-%, besonders bevorzugt 0,5 bis 6 Gew.-%, ganz besonders bevorzugt 1 bis 5 Gew.-% bezogen auf die Gesamtmasse der Zusammensetzung eingesetzt.

Die Zusammensetzung umfassend das Indium-Halogen-Alkoxid kann dieses gelöst, d.h. dissoziiert bzw. auf molekularer Ebene komplexiert mit Lösemittelmolekülen, oder in flüssiger Phase dispergiert aufweisen.

Das erfindungsgemäße Verfahren eignet sich - in dem Falle, dass nur Indium-haltige Precursoren eingesetzt werden, besonders gut zur Herstellung von In₂O₃-Schichten mit hoher Qualität und guten Eigenschaften. Besonders gute Schichten resultieren, wenn der einzige eingesetzte Precursor ein Indium-Halogen-Alkoxid ist.

Die Zusammensetzung kann jedoch neben dem Indium-Halogen-Alkoxid noch andere Precursoren, bevorzugt Alkoxide und Halogen-Alkoxide anderer Elemente gelöst oder dispergiert aufweisen. Besonders bevorzugt sind Alkoxide und Halogen-Alkoxide von B, Al, Ga, Ge Sn, Pb, P, Zn und Sb. Ganz besonders vorteilhaft einsetzbare Alkoxide und Halogen-Alkoxide sind die Verbindungen Ga(OiPr)₃, Ga(OtBu)₃, Zn(OMe)₂, Sn(OtBu)₄. Entsprechend können durch Einsatz dieser Verbindungen Indiumoxid-haltige Schichten, die darüber hinaus die Elemente B, Al, Ga, Ge Sn, Pb, P, Zn und Sb bzw. ihre Oxide aufweisen, hergestellt werden.

Die Zusammensetzung weist weiterhin mindestens ein Lösemittel bzw. Dispersionsmedium auf. Somit kann die Zusammensetzung auch zwei oder mehr Lösemittel bzw. Dispersionsmedien aufweisen. Zur Erzielung besonders guter Indiumoxid-haltiger Schichten sollte jedoch nur ein Lösemittel bzw. Dispersionsmedium in der Zusammensetzung vorliegen.

Bevorzugt einsetzbare Lösemittel bzw. Dispersionsmedien sind aprotische und schwach protische Lösemittel bzw. Dispersionsmedien, d.h. solche ausgewählt aus der Gruppe der aprotischen unpolaren Lösemittel/Dispersionsmedien, d.h. der Alkane, substituierten Alkane, Alkene, Alkine, Aromaten ohne oder mit aliphatischen oder aromatischen Substituenten, halogenierten Kohlenwasserstoffe, Tetramethylsilan, der Gruppe der aprotischen polaren Lösemittel/Dispersionsmedien, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat und der schwach protischen Lösemittel/Dispersionsmedien, d.h. der Alkohole, der primären und sekundären Amine und Formamid. Besonders bevorzugt einsetzbare Lösemittel bzw. Dispersionsmedien sind Alkohole sowie Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, Butylacetat, Ethyllactat, Methoxyethanol, Butoxyethanol, N-Methyl-2-pyrrolidon (NMP), Tetralin, Ethylbenzoat und Diethylether. Ganz besonders bevorzugte Lösemittel bzw. Dispersionsmedien sind Methanol, Ethanol, Isopropanol, Tetrahydrofurfurylalkohol, tert-Butanol, Butylacetat, Ethyllactat, Methoxyethanol und Toluol sowie ihre Gemische.

Das Lösemittel bzw. Dispersionsmedium wird bevorzugt in Anteilen von 99,9 bis 90 Gew.-% bezogen auf die Gesamtmasse der Zusammensetzung eingesetzt.

Bevorzugt weist die bei dem erfindungsgemäßen Verfahren eingesetzte Zusammensetzung zur Erzielung einer besonders guten Verdruckbarkeit eine Viskosität von 1 mPa·s bis 10 Pa·s, insbesondere 1 mPa·s bis 100 mPa·s bestimmt nach DIN 53019 Teil 1 bis 2 und gemessen bei 20 °C auf. Entsprechende Viskositäten können durch Zugabe von Polymeren, Cellulosederivaten, oder z.B. unter der Handelsbezeichnung Aerosil erhältlichem SiO₂, und insbesondere durch PMMA, Polyvinylalkohol, Urethanverdicker oder Polyacrylatverdicker eingestellt werden.

Bei dem Substrat, das bei dem erfindungsgemäßen Verfahren eingesetzt wird, handelt es sich bevorzugt um ein Substrat bestehend aus Glas, Silicium, Siliciumdioxid, einem Metall- oder Übergangsmetalloxid, einem Metall oder einem polymeren Material, insbesondere PI, PEN, PEEK, PC oder PET.

Das erfindungsgemäße Verfahren ist besonders vorteilhaft ein Beschichtungsverfahren ausgewählt aus Druckverfahren (insbesondere Flexo/Gravur-Druck, Inkjet-Druck - ganz besonders bevorzugt kontinuierlicher, thermischer oder Piezo-Inkjet-Druck -, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating. Ganz besonders bevorzugt ist das erfindungsgemäße Verfahren ein Druckverfahren. Als Druckverfahren eignet sich insbesondere InkJet sowie Flüssigtonerverfahren (wie z.B. HP Indigo), da diese Verfahren sich besonders gut für eine strukturierte Auftragung des Druckmaterials eignet.

Nach dem Aufbringen der wasserfreien Zusammensetzung auf das Substrat wird diese mit elektromagnetischer Strahlung einer Wellenlänge ≤ 360 nm bestrahlt. Besonders bevorzugt erfolgt die Bestrahlung mit Licht einer Wellenlänge von 150 bis 300 nm.

Nach der Beschichtung und vor der Konvertierung wird das beschichtete Substrat weiterhin bevorzugt getrocknet. Entsprechende Maßnahmen und Bedingungen hierfür sind dem Fachmann bekannt. Die Trocknung unterscheidet sich von der Konvertierung dadurch, dass bei ihr bei Temperaturen, die im Wesentlichen noch keine Umwandlung des Materials bewirken, das Lösemittel bzw. Dispersionsmedium entfernt wird. Erfolgt die Trocknung auf thermischem Wege, beträgt die Temperatur nicht mehr als 120 °C.

Die abschließende Konvertierung zu einer Indiumoxid-haltigen Schicht erfolgt auf thermischem Wege. Bevorzugt erfolgt die abschließende Konvertierung durch Temperaturen von kleiner als 500 °C und größer als 120 °C. Besonders gute Ergebnisse können jedoch erzielt werden, wenn zur Konvertierung Temperaturen von 150 °C bis 400 °C eingesetzt werden. Verfahren zur Erzielung dieser Temperaturen beruhen bevorzugt auf der Nutzung von Öfen, Heißluft, Heizplatten, IR-Strahlern und Elektronenstrahlern.

Dabei werden typischerweise Konvertierungszeiten von einigen Sekunden bis hin zu mehreren Stunden verwendet.

Die thermische Konvertierung kann weiterhin dadurch unterstützt werden, dass vor, während oder nach der thermischen Behandlung UV-, IR- oder VIS-Strahlung eingestrahlt oder das beschichtete Substrat mit Luft bzw. Sauerstoff behandelt wird.

Die Güte der nach dem erfindungsgemäßen Verfahren erzeugten Schicht kann weiterhin durch eine an den Konvertierungsschritt anschließende kombinierte Temperatur- und Gasbehandlung (mit H₂ oder O₂), Plasmabehandlung (Ar-, N₂, O₂ oder H₂-Plasma), Laser-Behandlung (mit Wellenlängen im UV-, VIS- oder IR-Bereich) oder eine Ozon-Behandlung weiter verbessert werden.

Der Beschichtungsprozess kann zur Erhöhung der Dicke wiederholt werden. Dabei kann der Beschichtungsprozess dergestalt erfolgen, dass nach jedem einzelnen Auftrag mit elektromagnetischer Strahlung bestrahlt und dann konvertiert wird, oder aber es erfolgen mehrere Auftragungen, an die sich jeweils eine elektromagnetische Bestrahlung anschließt, mit einem einzigen thermischen Konvertierungsschritt nach dem letztem Auftrag.

Gegenstand der Erfindung sind weiterhin die über das erfindungsgemäße Verfahren herstellbaren Indiumoxid-haltigen Schichten. Besonders gute Eigenschaften haben dabei über das erfindungsgemäße Verfahren herstellbare Indiumoxid-haltige Schichten, die reine Indiumoxidschichten sind. Wie bereits zuvor ausgeführt, werden bei ihrer Herstellung nur indiumhaltige Precursoren, bevorzugt nur Indium-Halogen-Alkoxide, besonders bevorzugt nur ein Indium-Halogen-Alkoxid eingesetzt.

Die über das erfindungsgemäße Verfahren herstellbaren Indiumoxid-haltigen Schichten eignen sich vorteilhaft für die Herstellung von leitenden oder halbleitenden Schichten für elektronische Bauteile, insbesondere für die Herstellung von Transistoren (insbesondere Dünnschichttransistoren), Dioden, Sensoren oder Solarzellen.

Das nachfolgende Beispiel soll den Gegenstand der vorliegenden Erfindung näher erläutern.

### Beispiel

Auf ein dotiertes Siliciumsubstrat mit einer Kantenlänge von etwa 15 mm und mit einer ca. 200 nm dicken Siliciumoxid-Beschichtung und Fingerstrukturen aus ITO/Gold wurden 100 µl einer 2,5 Gew.-% Lösung von InCl(OMe)₂ in Ethanol aufgebracht. Dann erfolgt Spin Coating bei 2000 rpm (5 Sekunden). Das beschichtete Substrat wird direkt nach diesem Beschichtungsvorgang für 5 Minuten mit aus einer Quecksilberdampflampe stammenden UV-Strahlung im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit µ_{FET} = 5 cm²/Vs bei 30 V_{Ds} bestimmen.

### Vergleichsbeispiel (Indiumalkoxid als Precursor)

Auf ein dotiertes Siliciumsubstrat mit einer Kantenlänge von etwa 15 mm und mit einer ca. 200 nm dicken Siliciumoxid-Beschichtung und Fingerstrukturen aus ITO/Gold wurden 100 µl einer 2,5 Gew.-% Lösung von In(OiPr)₃ in Ethanol aufgebracht. Dann erfolgt Spin Coating bei 2000 rpm (5 Sekunden). Das beschichtete Substrat wird direkt nach diesem Beschichtungsvorgang für 5 Minuten mit aus einer Quecksilberdampflampe stammenden UV-Strahlung im Wellenlängenbereich von 150 - 300 nm bestrahlt. Anschließend wird das Substrat eine Stunde auf einer Heizplatte bei einer Temperatur von 350°C erhitzt. Nach der Konvertierung lässt sich in der Glove Box ein Wert für die Feldeffektbeweglichkeit µ_{FET} = 2,2 cm²/Vs bei 30 V_{Ds} bestimmen.

### Vergleichsbeispiel (ohne UV-Strahlung)

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl leiner 2,5 Gew.-% Lösung von InCl(OMe)₂ in Ethanol aufgebracht. Dann erfolgt Spin Coating bei 2000 rpm (5 Sekunden). Das beschichtete Substrat wird eine Stunde auf einer Heizplatte bei einer Temperatur von 350°C erhitzt. Nach der Konvertierung lässt sich in der Glove Box ein Wert für die Feldeffektbeweglichkeit µ_{FET} = 1,7 cm²/Vs bei 30 V_{Ds} bestimmen.

## Patentansprüche

1. Flüssigphasen-Verfahren zur Herstellung Indiumoxid-haltiger Schichten aus nichtwässriger Lösung,
**dadurch gekennzeichnet, dass**
eine wasserfreie Zusammensetzung enthaltend mindestens ein Indium-Halogen-Alkoxid der generischen Formel InX(OR)₂ mit R = Alkylrest und/oder Alkoxyalkylrest und X = F, Cl, Br oder I und mindestens ein Lösemittel bzw. Dispersionsmedium in der Reihenfolge der Punkte a) bis d) in wasserfreier Atmosphäre
a) auf ein Substrat aufgebracht,
b) die auf dem Substrat aufgebrachte Zusammensetzung mit elektromagnetischer Strahlung einer Wellenlänge ≤ 360 nm bestrahlt und
c) ggf. getrocknet wird, und dann
d) thermisch in eine Indiumoxid-haltige Schicht konvertiert wird.

2. Verfahren nach Anspruch 1,
**dadurch gekennzeichnet, dass**
das die Alkyl- bzw. Alkoxyalkylreste des mindestens einen Indium-Halogen-Alkoxids C1- bis C15-Alkoxy- oder Alkoxyalkylgruppen sind.

3. Verfahren nach Anspruch 2,
**dadurch gekennzeichnet, dass**
das Indium-Halogen-Alkoxid InCl(OMe)₂, InCl(OCH₂CH₂OCH₃)₂, InCl(OEt)₂, InCl(OiPr)₂ oder InCl(OtBu)₂ ist.

4. Verfahren nach einem der vorhergehenden Ansprüche,
**dadurch gekennzeichnet, dass**
das die wasserfreie Zusammensetzung neben dem Indium-Halogen-Alkoxid noch andere Precursoren, bevorzugt Alkoxide und Halogen-Alkoxide anderer Elemente, besonders bevorzugt Alkoxide und Halogen-Alkoxide von B, Al, Ga, Ge Sn, Pb, P, Zn und Sb, gelöst oder dispergiert aufweist.

5. Verfahren nach einem der vorhergehenden Ansprüche,
**dadurch gekennzeichnet, dass**
das Indium-Halogen-Alkoxid InX(OR)₂ in Anteilen von 0,1 bis 10 Gew.-% bezogen auf die Gesamtmasse der Zusammensetzung eingesetzt wird.

6. Verfahren nach einem der vorhergehenden Ansprüche,
**dadurch gekennzeichnet, dass**
das mindestens eine Lösemittel oder Dispersionsmedium Methanol, Ethanol, Isopropanol, Tetrahydrofurfurylalkohol, tert-Butanol, Butylacetat, Methoxyethanol oder Toluol ist.

7. Verfahren nach einem der vorherigen Ansprüchen,
**dadurch gekennzeichnet, dass**
das mindestens eine Lösemittel oder Dispersionsmedium in Anteilen von 90 bis 99,9 Gew.-% bezogen auf die Gesamtmasse der Zusammensetzung vorliegt.

8. Verfahren nach einem der vorhergehenden Ansprüche,
**dadurch gekennzeichnet, dass**
die Zusammensetzung eine Viskosität von 1 mPa·s bis 10 Pa·s aufweist.

9. Verfahren nach einem der vorhergehenden Ansprüche,
**dadurch gekennzeichnet, dass**
das Aufbringen der wasserfreien Zusammensetzung auf das Substrat über ein Druckverfahren, ein Sprühverfahren, ein Rotationsbeschichtungsverfahren, ein Tauchverfahren oder ein Verfahren ausgewählt aus der Gruppe bestehend aus Meniscus Coating, Slit Coating, Slot-Die Coating, und Curtain Coating erfolgt.

10. Verfahren nach Anspruch 9,
**dadurch gekennzeichnet, dass**
das Aufbringen über ein Inkjet-Druck-Verfahren ausgewählt aus kontinuierlichem, thermischem und Piezo-Inkjet-Druck erfolgt.

11. Verfahren nach einem der vorhergehenden Ansprüche,
**dadurch gekennzeichnet, dass**
das Bestrahlen der wasserfreien Zusammensetzung mit elektromagnetischer Strahlung einer Wellenlänge von 150 - 300 nm erfolgt.

12. Verfahren nach einem der vorhergehenden Ansprüche,
**dadurch gekennzeichnet, dass**
die Konvertierung thermisch durch Temperaturen größer 150 °C erfolgt.

13. Verfahren nach einem der vorhergehenden Ansprüche,
**dadurch gekennzeichnet, dass**
vor, während oder nach der thermischen Behandlung UV-, IR- oder VIS-Strahlung eingestrahlt wird.

## Claims

1. Liquid phase process for producing indium oxide-containing layers from nonaqueous solution,
**characterized in that**
an anhydrous composition containing at least one indium halogen alkoxide of the generic formula InX(OR)₂ where R = alkyl radical and/or alkoxyalkyl radical and X = F, Cl, Br or I and at least one solvent or dispersion medium is, in the sequence of points a) to d), in anhydrous atmosphere,
a) applied to a substrate,
b) the composition applied to the substrate is irradiated with electromagnetic radiation of wavelength ≤ 360 nm and
c) optionally dried, and then
d) converted thermally to an indium oxide-containing layer.

2. Process according to Claim 1,
**characterized in that**
the alkyl or alkoxyalkyl radicals of the at least one indium halogen alkoxide are C1-C15-alkoxy or alkoxyalkyl groups.

3. Process according to Claim 2,
**characterized in that**
the indium halogen alkoxide is InCl(OMe)₂, InCl(OCH₂CH₂OCH₃)₂, InCl(OEt)₂, InCl(OiPr)₂ or InCl(OtBu)₂.

4. Process according to any one of the preceding claims,
**characterized in that**
the anhydrous composition comprises, as well as the indium halogen alkoxide, also other precursors, preferably alkoxides and halogen alkoxides of other elements, more preferably alkoxides and halogen alkoxides of B, Al, Ga, Ge, Sn, Pb, P, Zn and Sb, in dissolved or dispersed form.

5. Process according to any one of the preceding claims,
**characterized in that**
the indium halogen alkoxide InX(OR)₂ is used in proportions of 0.1 to 10% by weight, based on the total mass of the composition.

6. Process according to any one of the preceding claims,
**characterized in that**
the at least one solvent or dispersion medium is methanol, ethanol, isopropanol, tetrahydrofurfuryl alcohol, tert-butanol, butyl acetate, methoxyethanol or toluene.

7. Process according to any one of the preceding claims,
**characterized in that**
the at least one solvent or dispersion medium is present in proportions of 90 to 99.9% by weight, based on the total mass of the composition.

8. Process according to any one of the preceding claims,
**characterized in that**
the composition has a viscosity of 1 mPa·s to 10 Pa·s.

9. Process according to any one of the preceding claims,
**characterized in that**
the anhydrous composition is applied to the substrate by means of a printing process, a spraying process, a rotary coating process, a dipping process, or a process selected from the group consisting of meniscus coating, slit coating, slot-die coating, and curtain coating.

10. Process according to Claim 9,
**characterized in that**
the application is effected via an inkjet printing process selected from continuous, thermal and piezo inkjet printing.

11. Process according to any one of the preceding claims,
**characterized in that**
the anhydrous composition is irradiated with electromagnetic radiation of wavelength 150-300 nm.

12. Process according to any one of the preceding claims,
**characterized in that**
the conversion is effected thermally by means of temperatures greater than 150°C.

13. Process according to any one of the preceding claims,
**characterized in that**
UV, IR or VIS radiation is injected before, during or after the thermal treatment.

## Revendications

1. Procédé en phase liquide pour la production de couches contenant de l'oxyde d'indium à partir d'une solution non aqueuse, **caractérisé en ce qu'**une composition anhydre, contenant au moins un alcoxyde d'indium et d'halogène de formule générique InX(OR)₂, dans laquelle R = un radical alkyle et/ou un radical alcoxyalkyle et X = F, Cl, Br ou I, et au moins un solvant ou milieu de dispersion, dans l'ordre des points a) à d), sous une atmosphère inerte
a) est appliquée sur un substrat,
b) la composition appliquée sur le substrat est irradiée par un rayonnement électromagnétique d'une longueur d'onde ≤ 360 nm et
c) le cas échéant séchée, puis
d) convertie thermiquement en une couche contenant de l'oxyde d'indium.

2. Procédé selon la revendication 1, **caractérisé en ce que** les radicaux alkyle ou alcoxyalkyle dudit au moins un alcoxyde d'indium-halogène sont des groupes C₁-C₁₅-alcoxy ou alcoxyalkyle.

3. Procédé selon la revendication 2, **caractérisé en ce que** l'alcoxyde d'indium-halogène est InCl(OMe)₂, InCl(OCH₂CH₂OCH₃)₂, InCl (OEt)₂, InCl (OiPr)₂ ou InCl (OtBu)₂.

4. Procédé selon l'une quelconque des revendications précédentes, **caractérisé en ce que** la composition anhydre présente, outre l'alcoxyde d'indium-halogène, encore d'autres précurseurs, de préférence des alcoxydes et des halogénoalcoxydes d'autres éléments, de manière particulièrement préférée des alcoxydes et des halogénoalcoxydes de B, d'Al, de Ga, de Ge, de Sn, de Pb, de P, de Zn et de Sb, sous forme dissoute ou dispersée.

5. Procédé selon l'une quelconque des revendications précédentes, **caractérisé en ce que** l'alcoxyde d'indiumhalogène InX(OR)₂ est utilisé en des proportions de 0,1 à 10% en poids par rapport à la masse totale de la composition.

6. Procédé selon l'une quelconque des revendications précédentes, **caractérisé en ce que** ledit au moins un solvant ou milieu de dispersion est le méthanol, l'éthanol, l'isopropanol, l'alcool tétrahydrofurfurylique, le tert-butanol, l'acétate de butyle, le méthoxyéthanol ou le toluène.

7. Procédé selon l'une quelconque des revendications précédentes, **caractérisé en ce que** ledit au moins un solvant ou milieu de dispersion se trouve en des proportions de 90 à 99,9% en poids par rapport à la masse totale de la composition.

8. Procédé selon l'une quelconque des revendications précédentes, **caractérisé en ce que** la composition présente une viscosité de 1 mPa·s à 10 mPa·s.

9. Procédé selon l'une quelconque des revendications précédentes, **caractérisé en ce que** l'application de la composition anhydre sur le substrat a lieu via un procédé d'impression, un procédé de pulvérisation, un procédé de revêtement par rotation, un procédé d'imprégnation ou un procédé choisi dans le groupe constitué par le revêtement par ménisque, le revêtement par fente, le revêtement par filière plate et le revêtement par rideau.

10. Procédé selon la revendication 9, **caractérisé en ce que** l'application a lieu via un procédé d'impression par jet d'encre, choisi parmi l'impression par jet d'encre continue, thermique ou piézo.

11. Procédé selon l'une quelconque des revendications précédentes, **caractérisé en ce que** l'irradiation de la composition anhydre a lieu à l'aide d'un rayonnement électromagnétique d'une longueur d'onde de 150-300 nm.

12. Procédé selon l'une quelconque des revendications précédentes, **caractérisé en ce que** la conversion a lieu thermiquement par des températures supérieures à 150°C.

13. Procédé selon l'une quelconque des revendications précédentes, **caractérisé en ce qu'**un rayonnement UV, IR ou VIS est irradié avant, pendant ou après le traitement thermique.
